(19) **Europäisches Patentamt / European Patent Office / Office européen des brevets**

(11) **EP 2 040 088 B1**

(12) # FASCICULE DE BREVET EUROPEEN

(45) Date de publication et mention de la délivrance du brevet:
**18.04.2018 Bulletin 2018/16**

(51) Int Cl.:
**G01R 33/09** *(2006.01)* **G11B 5/39** *(2006.01)*
**B82Y 25/00** *(2011.01)*

(21) Numéro de dépôt: **08290880.7**

(22) Date de dépôt: **18.09.2008**

(54) **Dispositif de mesure de l'induction magnétique comportant plusieurs bandes de film mince présentant des phénomènes de magnétorésistance colossale**

Vorrichtung zum Messen einer magnetischen Induktion mit mehreren Dünnfilmbändern, die einen kolossalen Magnetowiderstand aufweisen

Magnetic induction measuring apparatus having plural bands of thin films exhibiting colossal magnetoresistance phenomena

(84) Etats contractants désignés:
**DE FR LT**

(30) Priorité: **20.09.2007 FR 0706610**

(43) Date de publication de la demande:
**25.03.2009 Bulletin 2009/13**

(73) Titulaire: **State Scientific Research Institute Center for Physical Sciences and Technology**
**02300 Vilnius (LT)**

(72) Inventeurs:
- **Schneider, Markus**
  **79104 Freiburg (DE)**
- **Spahn, Emil**
  **79591 Eimeldingen (DE)**
- **Balevicius, Saulius**
  **02300 Vilnius (LT)**
- **Zurauskienè, Nerija**
  **02300 Vilnius (LT)**
- **Stankevic, Voitech**
  **02300 Vilnius (LT)**

(56) Documents cités:
EP-A- 0 710 734      EP-A- 1 460 150
WO-A-01/71824        WO-A-02/09126
US-A1- 2003 053 266  US-A1- 2007 096 228
US-B1- 6 753 561

- **GROSS R ET AL: "Physics of grain boundaries in the colossal magnetoresistance manganites" JOURNAL OF MAGNETISM AND MAGNETIC MATERIALS, ELSEVIER SCIENCE PUBLISHERS, AMSTERDAM, NL, vol. 211, no. 1-3, 1 mars 2000 (2000-03-01), pages 150-159, XP004202846 ISSN: 0304-8853**
- **YANG S Y ET AL: "Growth and characterization of La0.7Sr0.3MnO3 films on various substrates" JOURNAL OF MAGNETISM AND MAGNETIC MATERIALS, ELSEVIER SCIENCE PUBLISHERS, AMSTERDAM, NL, vol. 268, no. 3, 1 janvier 2004 (2004-01-01), pages 326-331, XP004472849 ISSN: 0304-8853**
- **GOLDMAN A M ET AL: "Cuprate/manganite heterostructures" JOURNAL OF MAGNETISM AND MAGNETIC MATERIALS, ELSEVIER SCIENCE PUBLISHERS, AMSTERDAM, NL, vol. 200, no. 1-3, 1 octobre 1999 (1999-10-01), pages 69-82, XP004364007 ISSN: 0304-8853**
- **KAISER C ET AL: "Magnetically engineered spintronic sensors and memory" PROCEEDINGS OF THE IEEE, IEEE. NEW YORK, US, vol. 91, no. 5, 1 mai 2003 (2003-05-01), pages 661-680, XP011096629 ISSN: 0018-9219**
- **NORTON D P: "Synthesis and properties of epitaxial electronic oxide thin-film materials" MATERIALS SCIENCE AND ENGINEERING R: REPORTS, ELSEVIER SEQUOIA S.A., LAUSANNE, CH, vol. 43, no. 5-6, 15 mars 2004 (2004-03-15), pages 139-247, XP004490876 ISSN: 0927-796X**

EP 2 040 088 B1

• CHEN G J ET AL: "Effect of substrate dependence on microstructure and magnetoresistance of lanthanum manganite films" MATERIALS SCIENCE AND ENGINEERING B, ELSEVIER SEQUOIA, LAUSANNE, CH, vol. 84, no. 3, 20 juillet 2001 (2001-07-20), pages 182-188, XP004245232 ISSN: 0921-5107

• VAN TENDELOO G ET AL: "Atomic and microstructure of CMR materials" JOURNAL OF MAGNETISM AND MAGNETIC MATERIALS, ELSEVIER SCIENCE PUBLISHERS, AMSTERDAM, NL, vol. 211, no. 1-3, 1 mars 2000 (2000-03-01), pages 73-83, XP004202835 ISSN: 0304-8853

## Description

L'invention concerne le domaine des capteurs de champs magnétiques notamment aptes à mesurer l'induction magnétique B et utilisant la magnétorésistance et a plus particulièrement pour objet un dispositif apte à mesurer l'induction magnétique B auquel il est soumis du type comportant un substrat recouvert par une bande de film mince présentant des phénomènes de magnétorésistance colossale connectée à des électrode.

Les capteurs de champs magnétiques aptes à mesurer l'induction magnétique B peuvent être utilisés comme moyens de détection d'un champ magnétique impulsionnel dans les réseaux de lignes d'alimentation électriques et les stations de transformation.

Typiquement, les mesures de champs magnétique impulsionnel sont effectuées en utilisant des capteurs inductifs basés sur le principe des phénomène d'induction électromagnétique de Faraday, ou des capteurs galvanomagnétiques basés sur le principe de l'effet Hall ou Gauss dans les semiconducteurs, ou des capteurs magnéto-optiques basés sur le principe de l'effet de rotation de Faraday.

Tous ces capteurs sont sensibles à l'intensité d'un champ magnétique et à l'angle entre la direction du champ magnétique et le plan actif du capteur. Par conséquent, ils ne peuvent être utilisés si l'une et l'autre de ces deux dernières caractéristiques changent simultanément. Or, c'est le cas dans certaines applications dont, par exemple, l'élaboration de métal magnétique ou les dispositifs de lancement et de compression du flux magnétique.

Dans ces conditions, pour mesurer seulement le champ magnétique, on utilise généralement, comme par example dans le brevet US 2007/096228, capteurs basés sur la magnétorésistance colossale négative utilisant des manganites polycristallines dont les atomes de manganèse sont soumis à un moment magnétique qui réduit la résistance de la manganite lorsque le capteur est soumis à un champ magnétique, cette réduction de la résistance ne dépendant que de l'intensité du champ magnétique et non pas dudit angle entre la direction du champ magnétique et le plan actif du capteur

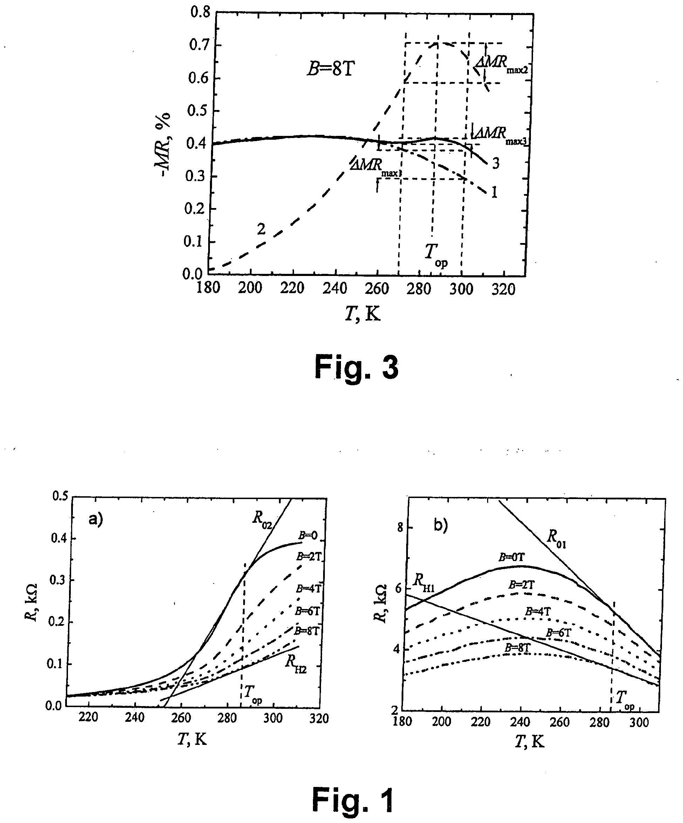

Toutefois, la valeur de la magnétorésistance colossale est dépendante de la température et présente un maximum à une certaine température Tm. Généralement, cette dépendance est asymétrique par rapport à Tm. Ainsi, lorsqu'on utilise un film polycristallin, la valeur de la magnétorésistance colossale dépend faiblement de la température pour des températures inférieures à Tm ; Par contre, comme montré sur la figure1, pour des températures supérieures à Tm, cette valeur décroît très rapidement lorsque la température augmente. Ces disparités peuvent donc perturber le fonctionnement des capteurs utilisant la magnétorésistance colossale, la forte dépendance de la valeur de la magnétorésistance colossale en fonction de la température diminuant la précision des résultats notamment en présence de variations de températures.

Le but de l'invention est de résoudre cet inconvénient en proposant un capteur magnétique à magnétorésistance colossale peu sensible à la température et permettant ainsi d'accroître la précision des résultats de mesure de champs magnétique obtenus, et ce même en cas de variation de température pendant les mesures,

La solution apportée est, selon une première caractéristique de l'invention un dispositif de mesure de l'induction magnétique comportant un premier substrat recouvert par au moins une première bande de film mince présentant des phénomènes de magnétorésistance colossale et connectée à des électrodes et caractérisé en ce que le premier substrat et ladite première bande ont une structure polycristalline et en ce qu'il comporte un deuxième substrat de structure monocristalline recouvert par au moins une seconde bande de film mince présentant des phénomènes de magnétorésistance colossale et connectée à des électrodes, cette seconde bande ayant une structure épitaxiale.

Selon une caractéristique additionnelle, les premières et seconde bande de film mince comporte au moins une partie en vis-à-vis, ces parties étant avantageusement séparés par un élément diélectrique, ce dernier pouvant par exemple consister en des moyens aptes à maintenir lesdites parties en vis-à-vis, comme de la colle.

Selon une caractéristique particulière, ladite première bande est connectée électriquement à une première et une seconde électrodes métalliques ayant chacune une forme de film mince, ces première et une seconde électrodes étant, au moins en partie, coplanaires.

Selon une caractéristique additionnelle, ladite seconde bande est connectée électriquement à une troisième et à une quatrième électrodes métalliques ayant chacune une forme de film mince, ces troisième et quatrième électrodes étant, au moins en partie, coplanaires.

Selon une caractéristique particulière, la première bande comporte une première face en contact avec le premier substrat et une seconde face, opposée à la première et recouverte partiellement par les première et seconde électrodes, la partie non recouverte de cette deuxième face étant préférentiellement sa partie médiane.

Selon une autre caractéristique particulière, la seconde bande comporte une première face en contact avec le deuxième substrat et une seconde face, opposée à la première et recouverte partiellement par les première et seconde électrodes, la partie non recouverte de cette deuxième face étant préférentiellement sa partie médiane.

Selon une caractéristique additionnelle, lesdites première et seconde bandes sont électriquement connectées en série, l'une des première et seconde électrodes étant solidaire de l'une des troisième et quatrième électrodes par un élément électriquement conducteur.

Selon une autre caractéristiques, les première et seconde électrodes et la partie médiane non recouverte de la première bande sont placées en vis-à-vis respectivement des quatrième et troisième électrodes et de la partie médiane non recouverte de la seconde bande et sont séparées d'elles par un élément intermédiaire diélectrique constitué par exemple, par de la colle.

Selon une caractéristique particulière, les premier et second substrats, les première et seconde bandes et les électrodes sont enrobés dans une enveloppe en matériau diélectrique, par exemple en époxy.

La température critique qui corresponds à un maximum de la valeur de la magnétorésistante colossale d'un film polycristallin doit être plus faible que celle du film épitaxial et, dans le domaine de mesure du capteur les valeurs de magnétorésistante colossale des premières bandes de film polycristallin doivent décroître lorsque la température croît tandis que les secondes bandes de film épitaxial doivent croître lorsque la température croît.

Lorsque la largeur des premières et secondes bandes est la même, le rapport $\alpha$ de la distances $d_e$ entre les troisième et quatrième électrodes connectées aux secondes bandes de film épitaxial la distances $d_p$ entre les premières et secondes électrodes connectées aux secondes bandes de film polycristallin, doit satisfaire l'équation

$$\alpha^2 A + \alpha B + C = 0 \tag{1}$$

avec

$$A = b_{He} \cdot k_{0e} - b_{0e} \cdot k_{He} \tag{2}$$

$$B = b_{Hp} \cdot k_{0e} + b_{He} \cdot k_{0p} - b_{0p} \cdot k_{He} - b_{0e} \cdot k_{Hp} \tag{3}$$

$$C = b_{Hp} \cdot k_{0p} - b_{0p} \cdot k_{Hp} \tag{4}$$

et

$$R_{0p} = b_{0e} + k_{0p} \cdot T \; ; \tag{5}$$

$$R_{H1} = b_{Hp} + k_{Hp} \, T \; ; \tag{6}$$

$$R_{0e} = \alpha.(b_{0e} + k_{0e} \cdot T) \; ; \tag{7}$$

$$R_{H1} = \alpha.(b_{He} + k_{He} \, T) \; ; \tag{8}$$

Les coefficients b et k sont déterminés par les équations (5) à (8) : ces équations décrivent les lignes droites qui sont, comme montré sur la figure 1, des tangentes des valeurs de la magnétorésistance colossale R en fonction de la température T, [R= f(T)] respectivement des première et seconde bandes respectivement de films épitaxial et polycristallin au point médian de la gamme de fonctionnement du capteur. En l'absence de champ magnétique, les valeurs de résistance [$R_{0p}$ = f(T)] $R_{0e}$ = f(T)], respectivement des première et seconde bandes sont obtenues expérimentalement. Il en est de même pour les valeurs Rhe et Rhp en fonction de la température et en présence d'une induction magnétique maximale auquel est prévu de fonctionner le capteur, en l'occurrence 8 Tesla.

D'autres avantages et caractéristiques de la présente invention apparaîtront dans la description de différentes variantes de réalisation de l'invention, en regard des figures annexées parmi lesquelles :

La figure 1 montre les valeurs de la résistance de films à magnétorésistance colossale en fonction de la température lorsqu'ils sont soumis à une induction magnétique de 8 teslas, la courbe a) correspondant à un film épitaxial et la courbe b) à un film polycristallin. Les lignes droites appelées $R_{0e}$, $R_{0p}$, $R_{He}$ et $R_{Hp}$ correspondent aux équations 5, 6 7 et 8 permettant de calculer le coefficient a.

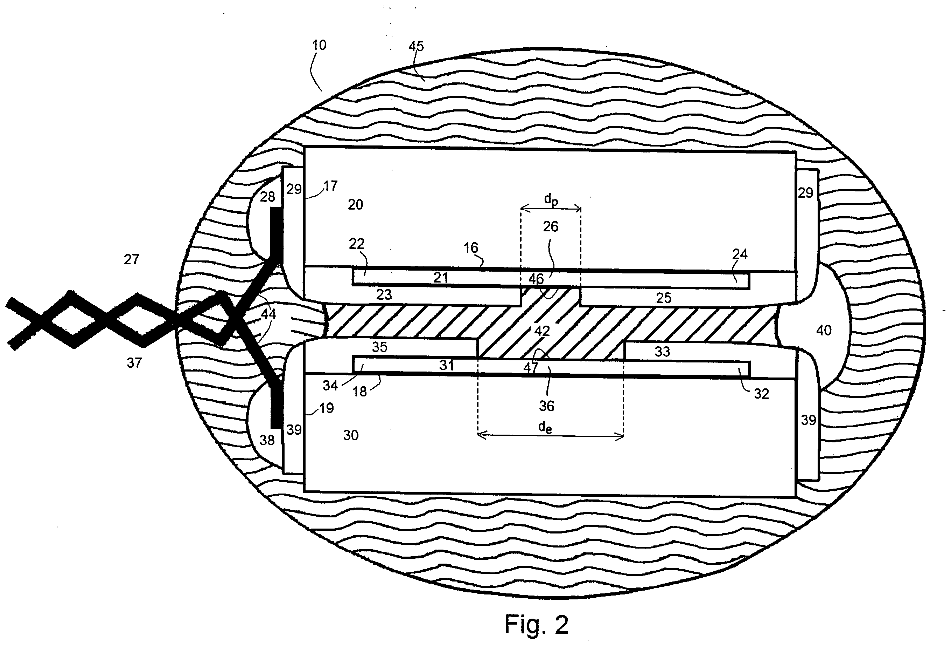

La figure 2 montre une coupe d'un capteur selon un mode de réalisation de l'invention

La figure 3 présente des courbes illustrant l'influence de la température sur la valeur de la magnétorésistance, (MR= $(R(H)-R_0)/R_0*100\%$)respectivement pour le film polycristallin (courbe 1), pour le film épitaxial (courbe 2) et pour un capteur selon cette variante de réalisation de l'invention, et ce, avec R(H) la valeur de la magnétorésistance en présence d'un champ magnétique H, $R_0$ la valeur de la magnétorésistance en l'absence dudit champ magnétique H. Cette figure présente aussi comment la gamme de température de fonctionnement du capteur est déterminée ainsi que la température médiane de la gamme de fonctionnement du capteur.

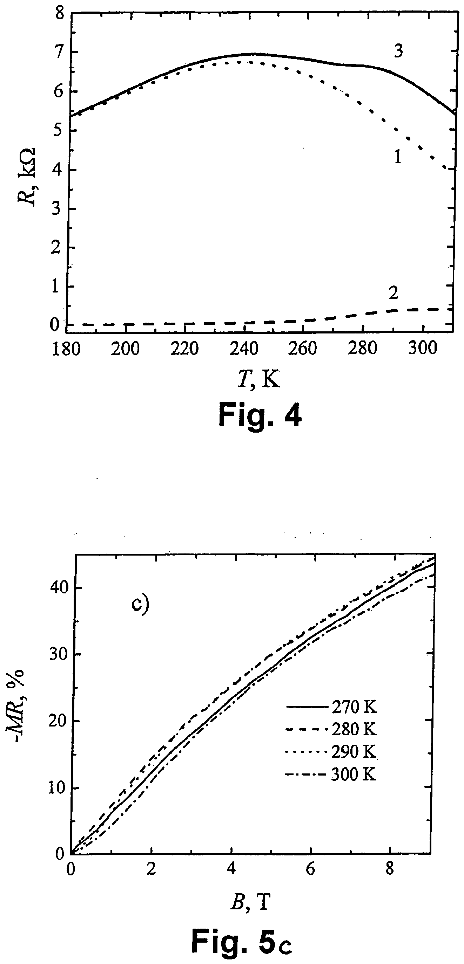

La figure 4 montre l'influence de la température sur la résistance d'un film présentant des propriétés de magnétorésistance colossale et en l'absence d'un champ magnétique appliqué, la courbe 1 correspondant à un capteur utilisant un film polycristallin; la- courbe 2 à un capteur utilisant un film épitaxial et la courbe 3 à un capteur selon le mode de réalisation décrit de l'invention.

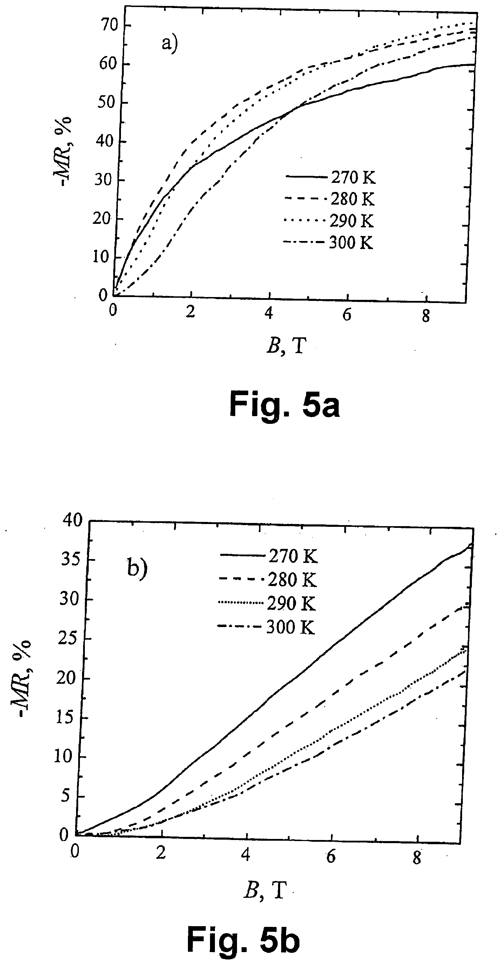

Les figures 5a, 5b et 5c montrent les valeurs de magnétorésistance en fonction de l'induction magnétique (B), la courbe a) correspondant à un capteur utilisant un film polycristallin , la courbe b) à un capteur utilisant un film épitaxial et la courbe c) à un capteur selon l'invention utilisant un film polycristallin connecté électriquement en série à film épitaxial.

La figure 2 montre une coupe d'un capteur 10 selon un mode de réalisation de l'invention. Ce capteur comporte un premier substrat 20 et un second substrat 30. Le premier substrat 20 a une structure polycristalline. Il est en matériau connu sous la dénomination « lucalox ». Sa longueur L est de 1 mm, sa largeur de 0,5mm et sont épaisseur de 0,5mm. L'une de ses deux surfaces principales 16 est recouverte par une première bande 21 de film de structure polycristalline comportant des propriétés de magnétorésistance colossale négative tandis que ses deux surfaces latérales 17 sont recouvertes par un revêtement métallique latéral 29 composé d'une sous couche de chrome et d'une couche en argent déposées par déposition sous vide. Cette première bande 21 de film de structure polycristalline a une longueur de 1mm, une largeur de 0,5mm et une épaisseur d'environ $0,4\mu m$. Ce film polycristallin est réalisé à base de manganite et a plus particulièrement comme formule $La_{0,83}Sr_{0,17}MnO_3$. Cette première bande 21 est, elle-même, partiellement recouverte d'un côté 22 par une première électrode 23 et d'un côté 24 par une seconde électrode 25, ces électrodes étant réalisées en argent par dépôt et ayant une largeur d'environ 0,5mm et une épaisseur d'environ $1\mu m$. Chacune de ces première et seconde électrode est connectée au revêtement métallique 29 de la surface latérale 17 située du même côté. Comme le montre cette figure, la bande comporte une partie médiane 26 de largeur dp= $50\mu m$ non recouverte par les électrodes et qui constitue une première partie active du capteur.

Le revêtement métallique latéral 29 connecté électriquement à la première électrode 23, est électriquement connecté, par une soudure 28 en alliage plomb-étain, à un second câble 37 La première électrode est connectée à un premier câble 27 électriquement conducteur d'alimentation en courant électrique.

Le second substrat 30 a une structure monocristalline. Il est fabriqué en $NdGaO_3$. Sa longueur L est de 1 mm, sa largeur de 0,5mm et sont épaisseur de 0,5mm. L'une de ses deux surfaces principales 18 est recouverte par une seconde bande 31 de film de structure épitaxiale comportant des propriétés de magnétorésistance colossale négative tandis que ses deux surfaces latérales 19 sont recouvertes par un revêtement métallique latéral 39 composé d'une sous couche de chrome et d'une couche en argent déposées par déposition sous vide. La seconde bande 31 de film de structure épitaxiale a une longueur de 1mm, une largeur de 0,5mm et une épaisseur d'environ $0,4\mu m$. Ce film épitaxial est réalisé à base de manganite et a plus particulièrement comme formule $La_{0,83}Sr_{0,17}MnO_3$. Cette seconde bande 31 est, elle-même, partiellement recouverte d'un côté 32 par une troisième électrode 33 et de l'autre côté 34 par une quatrième électrode 35, ces électrodes étant réalisées en argent par dépôt et ayant une largeur d'environ 0,5mm et une épaisseur d'environ $1\mu m$. Chacune de ces troisième et quatrième électrode est connectée au revêtement métallique 39 de la surface latérale 19 située du même côté. Comme le montre cette figure, la bande comporte une partie médiane 36 de largeur de=$200\mu m$ non recouverte par les troisième et quatrième électrodes et qui constitue une première partie active du capteur.

Le revêtement métallique latéral 39 connecté électriquement à la quatrième électrode 35, est électriquement connecté par soudure 38 en alliage plomb-étain à un second câble 37 électriquement conducteur d'alimentation en courant électrique tandis que la troisième électrode et connectée électriquement, par une soudure 40 en alliage plomb-étain, à la seconde électrode 25 via les revêtements métalliques 17 et 19 disposés du même côté. Ainsi, les premières et secondes bandes de film respectivement polycristallin et épitaxial sont connectées en série. Les premier et second câbles sont en cuivre de 0,3mm de diamètre et son torsadés et connectés à un générateur de tension entré eux non représenté.

Les première et seconde électrodes 23, 25 et la partie médiane 26 non recouverte de la première bande 21 sont placées en vis-à-vis respectivement des quatrième et troisième électrodes 33, 35 et de la partie médiane 36 non recouverte de la seconde bande 31 et sont séparées d'elles par un élément intermédiaire diélectrique 42 constitué, dans cet exemple de réalisation, par de la colle, par exemple du type « super glue » à base de « ceokream ».

Comme les largeurs actives $d_p$ et $d_e$ des première et seconde bandes de film respectivement polycristallin et épitaxial, sont respectivement égales à 50 et 200$\mu$m, le coefficient $\alpha$ est donc égal à 4.

L'ensemble constitué par les substrat, 10, 20, les premières et secondes bandes 21, 31, les électrodes 23, 25, 33, 35, les revêtements métalliques latéraux 29,39 et les soudures élément intermédiaire diélectrique 42, les soudures 28, 38, 40 et une partie 44 des câbles métalliques torsadés 27, 37, est enrobé dans une enveloppe en matériau diélectrique 45, en l'occurrence en époxy EPO-2.

La figure 3 montre les valeurs de la magnétorésistance en fonction de la température d'une part, courbe 1, avec un capteur ne comportant qu'un film polycristallin, d'autre part, courbe 2 avec un capteur n'utilisant qu'un film épitaxial et enfin, courbe 3, avec un capteur selon cet exemple de réalisation de l'invention. La courbe 3 montre que dans la gamme de température comprise entre 270 K et 300 K, les valeurs de la magnétorésistance colossale sont quasiment constantes alors qu'elles varient notablement avec le capteur comportant un seul film épitaxial (courbe 2)) et considérablement avec le capteur comportant un seul film polycristallin (courbe1).

Un coefficient $\beta$ apte à caractériser cette sensibilité à la température des valeurs de la magnétorésistance peut être le suivant :

$$\beta = \Delta MR_{max}/\Delta T/MR_{0T}.100\%$$

avec :

$\Delta MR_{max}$ : est la différence maximale de la magnétorésistance dans la gamme de température de fonctionnement

$\Delta T$ est la différence entre la température maximale T2 et la température minimale T1 de la gamme de température de fonctionnement

$MR_{0T}$ est la valeur de la magnétorésistance en l'absence de champ magnétique appliqué et à la température médiane $T_{op}$ de la gamme de température de fonctionnement $T_{op} = (T1 + T2)/2$.

Les calculs montrent que $\beta$ est égale à :

0,55%/K pour le capteur comportant un seul film épitaxial
0,84%/K pour le capteur comportant un seul film polycristallin
0,14%/K pour le capteur selon le mode de réalisation de l'invention.

Un capteur selon l'invention est donc 4 fois plus précis qu'un capteur comportant un seul film épitaxial et six fois plus précis qu'un capteur comportant un seul film polycristallin.

La figure 4 montre l'influence de la température sur la résistance d'un film présentant des propriétés de magnétorésistance colossale et en l'absence d'un champ magnétique appliqué, la courbe 1 correspondant à un capteur utilisant un film polycristallin, la courbe 2 à un capteur utilisant un film épitaxial et la courbe 3 à un capteur selon le mode de réalisation décrit de l'invention. On constate que, entre les températures extrêmes T1, T2 de la gamme de fonctionnement du capteur, (270- 300K) un capteur selon l'invention est celui qui présente une variation relative de résistance ($\Delta R/Rmoy$) ou $\Delta R$ sont les valeurs extrêmes de résistance sur cette gamme de température et Rmoy la valeur médiane de la résistance sur cette gamme, la plus faible, la variation étant d'environ 0,29 pour un film polycristallin, 1 pour un film épitaxial et 0,13 un capteur selon ce mode de réalisation de l'invention.

Les figures 5a, 5b et 5c montrent les valeurs de magnétorésistance en fonction de l'induction magnétique (B), et ce pour différentes températures comprises entre 270K et 300K, la figure 5a (courbes a) correspondant à un capteur utilisant un film polycristallin, la figure 5b (courbes b) à un capteur utilisant un film épitaxial et la figure 5c (courbes c) à un capteur selon le mode de réalisation décrit de l'invention.

La figure 5a montre qu'avec un seul film polycristallin, la valeur de la magnétorésistance varie de façon uniforme et homogène entre 280 et 290K mais le pourcentage de variation augmente conséquemment d'une part pour une température de 270K lorsque la valeur de l'induction magnétique est supérieure à 2 Teslas et, d'autre part, lorsque la température est de 300K, et ce, quelle que soit la valeur de l'induction magnétique.

La figure 5b montre qu'avec un seul film épitaxial, la valeur de la magnétorésistance varie de façon uniforme et relativement homogène entre 290 et 300K mais le pourcentage de variation augmente conséquemment d'une part pour une température de 280K lorsque la valeur de l'induction magnétique est supérieure à 2 Teslas et, d'autre part, lorsque la température est de 270K, et ce quelle que soit la valeur de l'induction magnétique.

La figure 5c montre qu'avec un capteur selon le mode de réalisation de l'invention, la valeur de la magnétorésistance varie de façon uniforme et relativement homogène sur toute la gamme de température de fonctionnement 270-300K et sur toute la gamme d'induction magnétique (0-8 Teslas) à laquelle est prévu de fonctionner le capteur.

Un capteur selon ce mode de réalisation de l'invention permet donc de déterminer une induction magnétique B sur une plage étendue, notamment 0-8 Teslas avec une bonne précision sur une gamme de température de fonctionnement trois fois plus étendue que dans le cadre de l'état de la technique.

De nombreuses modifications peuvent être apportées au mode de réalisation précédemment décrit. Ainsi, Il pourrait comporter plus de deux substrats et bandes associés.

## Revendications

1. Dispositif de mesure de l'induction magnétique comportant un premier substrat (20) recouvert par au moins une première bande de film mince (21) présentant des phénomènes de magnétorésistance colossale et connectée à des électrodes (23, 25) et **caractérisé en ce que** le premier substrat (20) et ladite première bande(21) ont une structure polycristalline et **en ce qu'**il comporte un deuxième substrat (30) de structure monocristalline recouvert par au moins une seconde bande de film mince (31) présentant des phénomènes de magnétorésistance colossale et connectée à des électrodes (33, 35), cette seconde bande ayant une structure épitaxiale.

2. Dispositif selon la revendication 1, **caractérisé en ce que** les premières et seconde bande de film mince (21, 31) comportent au moins une partie (26, 46) en vis-à-vis, les parties en vis-à-vis étant séparées par un élément diélectrique (42).

3. Dispositif selon l'une quelconque des revendications 1 et 2, caractérisé en ce ladite première bande (21) est connectée électriquement à une première et une seconde électrodes métalliques (23, 25) ayant chacune une forme de film mince, ces première et une seconde électrodes (23, 25) étant, au moins en partie, coplanaires.

4. Dispositif selon l'une quelconque des revendications 1 à 3, **caractérisé en ce que** ladite deuxième bande (31) est connectée électriquement à une troisième et une quatrième électrodes métalliques (33, 35) ayant chacune une forme de film mince, ces troisième et une quatrième électrodes (33, 35) étant, au moins en partie, coplanaires.

5. Dispositif selon l'une quelconque des revendications 1 à 4, **caractérisé en ce que** la première bande (21) comporte une première face en contact avec le premier substrat (20) et une seconde face, opposée à la première et recouverte partiellement par les première et seconde électrodes (23, 25), la partie non recouverte (26) de cette deuxième face étant préférentiellement sa partie médiane .

6. Dispositif selon la revendication 5, **caractérisé en ce que** la seconde bande (31) comporte une première face en contact avec le deuxième substrat (30) et une seconde face, opposée à la première et recouverte partiellement par des troisième et quatrième électrodes (33, 35), la partie non recouverte (36) de cette deuxième face étant préférentiellement sa partie médiane.

7. Dispositif selon l'une quelconque des revendications 1 à 6, **caractérisé en ce que** lesdites première et seconde bandes (21, 31) sont électriquement connectées en série, l'une des première et seconde électrode (23, 25) étant solidaire de l'une des troisième et quatrième électrodes (33, 35) par un élément électriquement conducteur (29, 39, 40).

8. Dispositif selon la revendication 7, **caractérisé en ce que** les première et seconde électrodes (23, 25) et la partie médiane (26) non recouverte de la première bande (21) sont placées en vis-à-vis respectivement des quatrième et troisième électrodes (33, 35) et de la partie médiane (36) non recouverte de la seconde bande (31) et sont séparées d'elles par un élément intermédiaire diélectrique (42) constitué par exemple, par de la colle.

9. Dispositif selon l'une quelconque des revendications 1 à 8, **caractérisé en ce que** les premier et second substrats (20, 30), les première et seconde bandes (21, 31) et les électrodes (23, 25, 33, 35) sont enrobés dans une enveloppe (45) en matériau diélectrique, par exemple en époxy.

## Patentansprüche

1. Vorrichtung zur Messung der magnetischen Induktion bestehend aus einem ersten Substrat (20), das mit mindestens einem ersten Dünnfolien-Band (21) mit CMR-Effekt und Elektrodenanschluss (23, 25) abgedeckt ist, **dadurch gekennzeichnet, dass** das erste Substrat (20) und das erwähnte erste Band (21) eine polykristalline Struktur aufweisen und dass ein zweites Substrat (30) mit monokristalliner Struktur vorhanden ist, das mindestens mit einem zweiten Dünnfolien-Band (31) mit CMR-Effekt und Elektrodenanschluss (33, 35) abgedeckt ist, wobei dieses zweite Band eine Expitaxie-Struktur besitzt.

**2.** Vorrichtung nach Anspruch 1, **dadurch gekennzeichnet, dass** das erste und zweite Dünnfolien-Band (21, 31) mindestens ein gegenüber angeordnetes Element (26, 46) aufweisen, wobei die gegenüberliegenden Elemente durch ein dielektrisches Bauteil (42) voneinander getrennt sind.

**3.** Vorrichtung nach einem der Ansprüche 1 oder 2, **dadurch gekennzeichnet, dass** das erwähnte erste Band (21) mit einer ersten und zweiten Metallelektrode (23, 25) in Form einer Dünnfolie elektrisch verbunden ist, die zumindest teilweise koplanar sind.

**4.** Vorrichtung nach einem der Ansprüche 1 bis 3, **dadurch gekennzeichnet, dass** das erwähnte zweite Band (31) mit einer dritten und vierten Metallelektrode (33, 35) in Form einer Dünnfolie elektrisch verbunden ist, wobei diese Elektroden (33, 35) zumindest teilweise koplanar sind.

**5.** Vorrichtung nach einem der Ansprüche 1 bis 4, **dadurch gekennzeichnet, dass** das erste Band (21) eine erste Fläche in Kontakt mit dem ersten Substrat (20) und eine zweite Fläche gegenüber der ersten Fläche mit teilweiser Abdeckung durch die erste und zweite Elektrode (23, 25) aufweist, wobei der nicht abgedeckte Bereich (26) dieser zweiten Fläche vorzugsweise die Mitte darstellt.

**6.** Vorrichtung nach Anspruch 5, **dadurch gekennzeichnet, dass** das zweite Band (31) eine erste Fläche in Kontakt mit dem ersten Substrat (30) und eine zweite Fläche gegenüber der ersten Fläche mit teilweiser Abdeckung durch die dritte und vierte Elektrode (33, 35) aufweist, wobei der nicht abgedeckte Bereich (36) dieser zweiten Fläche vorzugsweise die Mitte darstellt.

**7.** Vorrichtung nach einem der Ansprüche 1 bis 6, **dadurch gekennzeichnet, dass** das erste und zweite Band (21, 31) elektrisch in Reihe geschaltet sind, wobei die erste oder zweite Elektrode (23, 25) mit der dritten oder vierten Elektrode (33, 35) durch ein elektrisch leitendes Element (29, 39, 40) miteinander verbunden sind.

**8.** Vorrichtung nach Anspruch 7, **dadurch gekennzeichnet, dass** die erste und zweite Elektrode (23, 25) sowie die nicht abgedeckte Mitte (26) des ersten Bandes (21) jeweils gegenüber der dritten und vierten Elektrode (33, 35) sowie der nicht abgedeckten Mitte (36) des zweiten Bandes (31) angeordnet und durch ein dielektrisches Zwischenelement (42), wie zum Beispiel Kleber, voneinander getrennt sind.

**9.** Vorrichtung nach einem der Ansprüche 1 bis 8, **dadurch gekennzeichnet, dass** das erste und zweite Substrat (20, 30), das erste und zweite Band (21, 31) und die Elektroden (23, 25, 33, 35) mit einer Ummantelung (45) aus dielektrischem Material, beispielsweise Epoxidharz, umgeben sind.

**Claims**

**1.** Device for measuring the magnetic induction, including a first substrate (20) covered with at least a first tape of thin film (21) exhibiting Colossal Magnetoresistance (CMR) phenomenon and connected to electrodes (23, 25), **characterized in that** the first substrate (20) and said first tape (21) have a polycrystalline structure and that there is a second single-crystal substrate (30) covered with at least a second tape of thin film (31) exhibiting Colossal Magnetoresistance (CMR) phenomenon and connected to electrodes (33, 35), whereby the second tape has an expitaxial structure.

**2.** Device according to claim 1, **characterized in that** the first and the second tape of thin film (21, 31) have at least two parts in front of each other (26, 46), whereby these parts placed in front of each other are separated by a dielectric element (42).

**3.** Device according to claim 1 or 2, **characterized in that** said first tape (21) is electrically connected to a first and a second thin film metallic electrode (23, 25), the first and the second electrode (23, 25) being at least partially coplanar.

4. Device according to claim 1, or 2, or 3, **characterized in that** said second tape (31) is electrically connected to a third and a fourth thin film metallic electrode (33, 35), the third and the fourth electrode (33, 35) being at least partially coplanar.

5. Device according to claim 1, or 2, or 3, or 4, **characterized in that** the first tape (21) is composed of a first side in contact with the first substrate (20) and a second side in front of the first side that is partially covered with the first and the second electrode (23, 25), whereby the non-covered part (26) of the second side is preferably its median part.

6. Device according to claim 5, **characterized in that** the second tape (31) is composed of a first side in contact with the second substrate (30) and a second side in front of the first side that is partially covered with the third and the fourth electrode (33, 35), whereby the non-covered part (36) of the second side is preferably its median part.

7. Device according to claim 1, or 2, or 3, or 4, or 5, or 6, **characterized in that** said first and second tapes (21, 31) are electrically connected in series, whereby one of the first or second electrode (23, 25) is integrally connected to one of the third or fourth electrode (33, 35) using an electrically conductive element (29, 39, 40).

8. Device according to claim 7, **characterized in that** the first and the second electrode (23, 25) as well as the median part (26) not covered with the first tape (21) are placed in front of the third and the fourth electrode (33, 35) as well as the median part (36) not covered with the second tape (31) respectively and are separated from each other by an intermediate dielectric element (42), such as glue.

9. Device according to claim 1, or 2, or 3, or 4, or 5, or 6, or 7, or 8, **characterized in that** the first and the second substrate (20, 30), the first and the second tape (21, 31) as well as the electrodes (23, 25, 33, 35) are covered with a dielectric coating (45), such as epoxy resin.

**Fig. 3**

**Fig. 1**

Fig. 2

Fig. 4

Fig. 5c

**Fig. 5a**

**Fig. 5b**

**EP 2 040 088 B1**

## RÉFÉRENCES CITÉES DANS LA DESCRIPTION

**Documents brevets cités dans la description**

- US 2007096228 A